Europäisches Patentamt

(19) European Patent Office

Office européen des brevets

(11) Publication number: **0 153 777**
**A2**

## (12) EUROPEAN PATENT APPLICATION

(21) Application number: 85200175.9

(22) Date of filing: 12.02.85

(51) Int. Cl.⁴: **H 03 H 7/38**

(30) Priority: 17.02.84 GB 8404220

(43) Date of publication of application:
04.09.85 Bulletin 85/36

(84) Designated Contracting States:
DE FR GB IT

(71) Applicant: PHILIPS ELECTRONIC AND ASSOCIATED
INDUSTRIES LIMITED
Arundel Great Court 8 Arundel Street
London WC2R 3DT(GB)

(84) Designated Contracting States:
GB

(71) Applicant: N.V. Philips' Gloeilampenfabrieken
Groenewoudseweg 1
NL-5621 BA Eindhoven(NL)

(84) Designated Contracting States:
DE FR IT

(72) Inventor: Polwart, Timothy
c/o Mel Limited Manor Royal
Crawley Sussex RH10 2PZ(GB)

(74) Representative: Somerfield, Clive Julian et al,
Philips Electronic and Associated Industries Limited
Patent Department Mullard House Torrington Place
London WC1E 7HD(GB)

(54) RF circuit switching.

(57) In an RF circuit comprising an inductive element with an associated electrically-operable switch which may be subjected in use to high RF potentials, for example an inductor (LM) with a short-circuiting switch (SM) thereacross in an antenna tuning unit, the inductive element (LM) comprises a plurality of windings (W1, W2, W3) which electrically are in parallel at RF and mutually isolated at DC, and electrical power for operating the switch (SM) is supplied via the windings (W1, W2, W3) which thus provide RF isolation between the switch (SM) and the source of power. Control signals for the switch (SM) may be supplied via an optoelectronic coupler (OPTO TX/RX) or via an additional winding.

FIG. 2

## "RF CIRCUIT SWITCHING"

The invention relates to RF circuit switching and more specifically to alleviating the problem of operating switching devices which may be subject in use to large RF voltages.

In particular, the invention relates to an RF circuit comprising at least one inductive element and electrically-operable switch means, wherein a point on said one inductive element is selectably electrically connectable in the operating RF range of the circuit to another point in the circuit by the switch means for passing a substantial RF current therebetween in use, and wherein RF isolation is provided between a source of electrical power required for the operation of the switch means and at least part of the switch means which in use is subjected to a large RF potential with respect to said source.

A typical such circuit is to be found in an antenna tuning unit (ATU) which is used to match an antenna to a transmitter and/or receiver. Since with many antennas the antenna impedance varies with frequency, it is generally necessary to adjust the ATU so as to re-tune the system when the frequency of transmission or reception is changed. The RF circuit of the ATU may, for example, be a T-network wherein each of the two series arms (which together form the cross-bar of the T) comprises a variable inductance and wherein the shunt arm (the vertical member of the T) comprises a variable capacitance. In order to be able to vary the inductance of each series arm, the latter may comprise a series of inductors each with a respective switching device connected across it to enable it to be substantially short-circuited at RF. When the transmitter is in use, large RF voltages (e.g. 700 volts) may be developed across an inductor which is not short-circuited, and furthermore the RF voltage with respect to earth will increase along the series arms from a fairly low value at the matched end (the end connected to the transmitter) to a high value (e.g. 3kV) at the unmatched end (the end connected to the antenna). It is therefore necessary that the switching device connected across an inductor should be able to withstand large voltages not only across

0153777

itself but also especially with respect to earth, the source of electrical power required for the operation of the switch normally being close to earth potential.

It has been conventional to use vacuum relays for this purpose. These have the disadvantages of being fairly expensive and of consuming quite a lot of power; low-power versions are available but are even more expensive. Furthermore, some applications which now exist make it desirable to be able to switch with greater speed than that of which relays are capable.

Solid-state switching devices such as PIN diodes have become available which are capable of withstanding the voltages that may be produced across inductors in an ATU by the transmitter. However, there still remains the problem of supplying bias voltages from a source close to earth potential to a switching device that may be subject to high RF voltages. RF isolation might be provided by including an RF choke in each lead from the source to the switching device. (The use of such a choke in each lead to a PIN diode switch in order to provide decoupling, the switch in this case being across a series delay line in an RF circuit, is disclosed in GB 2 104 746 A.) However, this has the disadvantages that each such choke has stray capacitance which in combination with the inductance of the choke can exhibit a parallel resonance with a large circulating current, resulting in substantial dissipation of power. In addition, especially if the choke is to withstand very high RF voltages, e.g. 3kV, it will need to be large, with well-spaced windings.

According to the invention, an RF circuit as set forth in the second paragraph of this specification is characterised in that said one inductive element comprises a plurality of inductive windings which electrically are substantially in parallel with each other in the operating RF range of the circuit and substantially isolated from each other at DC, and in that the circuit is operable to supply from said source via at least two said windings to the switch means electrical power required for the operation thereof, whereby to provide said RF isolation. Such an arrangement inherently provides the desired RF isolation and may be significantly cheaper and easier to manufacture and substantially more compact than, for example, an arrangement with a separate choke in each power supply lead to a switch.

Where the RF circuit comprises a plurality of inductive elements connected in series with each other and further comprises a plurality of electrically-operable switch means each associated with a respective one of the inductive elements (as is typically the case in an ATU), then suitably each of the inductive elements comprises a plurality of inductive windings, and a plurality of respective windings of each element are respectively connected in series with respective windings of each of the other elements so that the circuit is operable to supply from said source via the windings to each of the switch means electrical power required for the operation thereof.

The or each switch means may be selectably electrically connectable in parallel at RF with said one inductive element or a respective one of the inductive elements for substantially short-circuiting the element in the operating RF range of the circuit, as in an ATU. As an alternative, the invention may for example be embodied in an RF circuit in which in use a connection is established to a selected tap of a multi-tap inductor or transformer.

For controlling the operation of the switch means, the circuit may further comprise opto-electronic means for coupling signals to the, or at least one of the, switch means.

As an alternative, said one inductive element may comprise an additional winding to couple signals to the, or its respective associated, switch means for controlling the operation thereof. In a circuit comprising a plurality of $N$ inductive elements ($N \geqslant 2$) connected in series with each other as set forth above, the $M$th element of the series may have ($N - M$) additional windings to couple signals to the switch means respectively associated with the ($N - M$) succeeding elements of the series for controlling operation thereof.

Suitably, the or each switch means comprise at least one solid-state switch device. Said one or each inductive element may comprise at least three windings, and the or each respective switch means may comprise at least one solid-state two-terminal diode switch device biasable to two states respectively of high and low RF impedance by two respective direct voltages applied between the members of two respective pairs of the three windings, such as a PIN diode.

In such a circuit:-

a first terminal of said one two-terminal diode device of the or each switch means may be coupled at DC and closely coupled at RF to a point on a first of said three windings of said one or the associated inductive element,

the second terminal of said one two-terminal diode device of the or each switch means may be connected by a first path to a point on a second of said three windings of said one or the associated inductive element, the first path comprising in series between the second terminal and said point on the second winding first additional switch means selectably controllable to present either a high or a low DC resistance, and be connected by a second path to a point on the third winding of said one or the associated inductive element, the second path comprising in series between the second terminal and said point on the third winding a high resistive DC impedance, and

in use:

said points respectively on the second and third windings are at substantially the same RF potentials and are closely RF-coupled to said second terminal;

when the first additional switch means are controlled so as to present a low DC resistance, said one two-terminal diode device is DC-biassed via the first and second windings and the first path to its state of low RF impedance; and

when the first additional switch means are controlled so as to present a high DC resistance, said one two-terminal diode device is DC-biassed via the first and third windings and said high resistive

. DC impedance of the second path to its state of high RF impedance, said points on the second and third windings then each being at an RF potential differing from that of said point on the first winding.

To increase the speed at which the diodes are switched off, the second path may further comprise second additional switch means which are selectably controllable to present either a high or a low DC resistance and which are connected in parallel with said high resistive DC impedance, wherein in use the second additional switch means normally present a high DC resistance but when the first additional switch means are controlled so as to change from presenting a low DC resistance to presenting a high DC resistance, the second additional switch means are controlled so as briefly to present a low DC resistance whereby to increase the rate of change of biassing of said one two-terminal diode device from its low RF impedance state to its high RF impedance state.

The or each switch means may comprise two two-terminal diode devices whereof corresponding first terminals are respectively closely coupled at DC to opposite ends of a first of said three windings, and at RF to opposite ends of all three windings, of said one or the associated inductive element and whereof the corresponding second terminals are closely coupled together at DC and RF and closely coupled at RF to the mid-points of all three windings of said one or the associated inductive element.

Embodiments of the invention will now be described, by way of example, with reference to the diagrammatic drawings, in which:-

Figure 1 indicates schematically the matching network of an antenna tuning unit;

Figure 2 shows in detail portions of one arm of the network of Figure 1 in an arrangement embodying the invention, and

Figure 3 is a schematic circuit diagram of an operating control circuit for the arrangement of Figure 2.

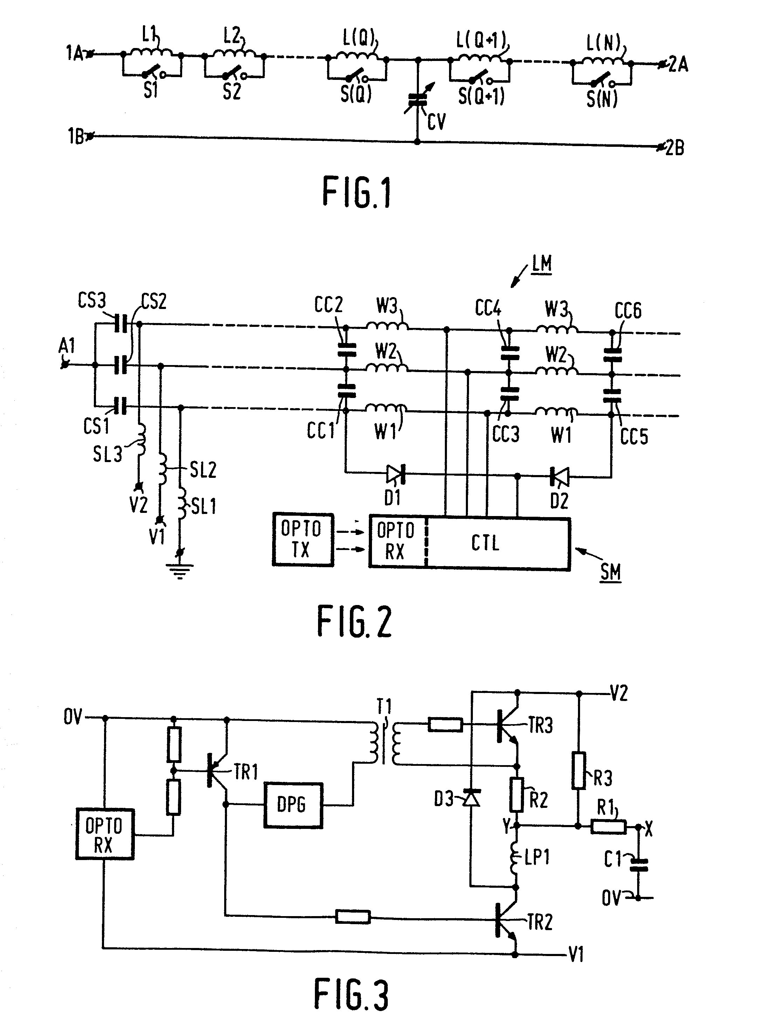

Referring to Figure 1, the matching network of an antenna tuning unit has two ports each with two terminals 1A, 1B and 2A, 2B respectively. The network comprises two series arms with a total

of N inductors, L1, L2 .... LN  connected in series between terminals 1A and 2A, there being Q inductors L1-LQ in the left-hand arm (as drawn). Connected in parallel with each inductor in each of the two arms is a respective associated switch, S1 ... SQ and S(Q+1) ... S(N) respectively. The line interconnecting the two series arms, i.e. betweeen LQ and L(Q+1), is connected to one end of a shunt arm comprising a selectably variable capacitance CV, the other end of this shunt arm being connected to a common line interconnecting terminals 1B and 2B (usually RF ground). In use, a first of the ports (in this case 1A,1B) is connected to a radio transmitter and the other port (2A,2B) is connected to an antenna. The impedances of the series and shunt arms are adjusted so that at the operating frequency, the combination of the antenna and the antenna tuning unit presents at the first port an impedance substantially equal to a desired value, typically 50 ohms. In the case of each of the series arms, the impedance is adjusted by closing selected ones of the switches, thereby short-circuiting the respective associated inductors, so that the inductance of the arm is the total inductance of the inductors the respective switches across which are open. There may for example be five inductors in each arm, and the values of the inductors in each arm may typically be in binary progression.

Figure 2 shows two portions of that series arm (the left-hand arm in Figure 1) which is connected between terminal 1A and the shunt arm, namely the end of the arm adjacent terminal 1A, and the Mth inductor LM with its associated switch SM. The inductor LM comprises three similar windings W1, W2 and W3 which are respectively connected in series with corresponding windings of each of the other inductors in both of the series arms, forming three sets of windings. The three sets of windings are connected together at RF adjacent terminal 1A via respective series capacitors CS1, CS2 and CS3 (and similarly adjacent terminal 2A, not shown in Figure 2), the capacitors providing mutual isolation of the sets of windings at DC. In each inductor, the three windings are very closely mutually coupled at RF; to assist in providing such coupling, coupling capacitors are connected between the windings at each end and the mid-points thereof as shown by capacitors CC1-CC6 at inductor LM, and further coupling capacitors (not shown) may be connected between the windings at intervals therealong.

The shunt arm of the ATU, comprising the variable capacitance CV (not shown in Figure 2), is connected to the interconnection of two corresponding windings respectively in the two series arms, i.e. between inductors LQ and L(Q+1). Since in each of the two inductors LQ and L(Q+1) adjacent the shunt arm there is very close mutual coupling at RF of the three respective windings, the three interconnections between corresponding windings in those two inductors must in use all be at substantially the same RF potential, and hence the connection of the shunt arm to one of those interconnections is effectively a connection to all three interconnections at RF.

The respective switch SM for the M̲th inductor comprises two solid-state two-terminal switch devices D1 and D̲2, in this case PIN diodes, corresponding first terminals (in this case the anodes) of which are respectively connected to opposite ends of a first of the windings, W1. The corresponding second terminals (in this case the cathodes) of the switch devices D1 and D2 are connected together at a common point CP.

Bias voltages for the diodes D1 and D2 are derived from direct potentials respectively applied to the three sets of windings via respective supply chokes SL1, SL2 and SL3 which are connected to the sets of windings between the isolating series capacitors CS1-CS3 and the windings of the first choke (L1: not shown in Figure 2). The supply chokes are shown in Figure 2 as being separate, but may for convenience and compactness comprise, for example, three windings around a common former. The first winding W1 is earthed, a fairly small negative voltage V1 for forward-biasing the diodes is applied to the second winding W2, and a large positive voltage V2 for reverse-biasing the diodes is applied to the third winding W3. The supply chokes SL1-SL3 provide

PHB 33052 EP
0153777

RF isolation between the inductors and the source of the bias potentials, i.e. the source of electrical power required for the operation of the switches.

The common point CP of the diodes, and three leads respectively connected to the mid-points of the windings W1, W2 and W3, are connected to an operating control circuit CTL. This circuit comprises the receiver, OPTO RX, of an opto-electronic coupler that further comprises a corresponding transmitter OPTO TX. The opto-electronic coupler is used to couple control signals to the circuit CTL, and isolates the source of the control signals from the high RF voltages that may be present in the circuit CTL in use.

Figure 3 is a schematic circuit diagram indicating important elements of one form of operating control circuit CTL, various points of which are respectively supplied as shown with the direct potentials OV (earth), V1, and V2 from the windings W1-W3 respectively. The output of the opto-electronic receiver OPTO RX is coupled via a potential divider to the base of a pnp first transistor TR1, the collector of which is coupled to the base of a npn second transistor TR2. The collector of TR1 is also coupled to the input of a delay and pulse generating circuit DPG which responds only to a negative-going edge of a signal at its input. Its output is coupled via an isolating transformer T1 to the base of a npn third transistor TR3. The transistors TR2 and TR3 function as additional switches for controlling the biassing of the PIN diodes D1 and D2.

The common point CP of the diodes D1 and D2 is connected to point X of the circuit CTL. This point X is coupled at RF to the mid-point of the inductor LM via a capacitor C1 connected to the mid-point of the earthed winding W1. Point X is connected via a low resistance R1 (for example 47 ohms) to a point Y which lies on a series connection of the collector-emitter paths of transistors TR2 and TR3 between the potentials V1 and V2. Point Y is connected via a fairly low resistance R2 (for example 500 ohms) to the emitter of TR3 and a via an inductor LP1 to the collector of TR2;

point Y is also connected via a high resistance R3 (for example 470 kilohms) to potential V2. A diode D3 is connected between the junction of the inductor LP1 with the collector of transistor TR2 and the potential V2.

In use, when the opto-electronic coupler is inactive, the output of its receiver OPTO RX is substantially open-circuit and hence at earth potential. Thus, the base of TR1 is at earth potential, while its collector and the base of TR2 are substantially at V1. The base and emitter of TR3 are substantially at V2. Hence each of the transistors TR1, TR2 and TR3 is off. Points X and Y are therefore substantially at V2, and the diodes D1 and D2 are reverse-biased. Hence the switch SM across inductor LM is open.

When it is desired that the switch SM be closed in order substantially to short-circuit the inductor LM at RF, the opto-electronic coupler is actuated: the resultant current through its receiver brings the voltage at its output substantially to V1. As a result, transistor TR1 is turned on. The positive-going signal edge at the input of the circuit DPG has no effect thereon, but the transistor TR2 is turned on. This closely couples point Y and hence point X to the fairly small negative potential V1, and thus the PIN diodes D1 and D2 are forward-biassed for RF conduction, the bias current being limited by R1. Opposite ends of winding W1 of the inductor LM are thus maintained at substantially the same RF potential, substantially short-circuiting the inductor LM at RF. (During the RF half-cycles in which the RF current through a respective one of the PIN diodes D1 and D2 opposes the direct bias current, the stored change in the diode maintains the diode in RF conduction.)

When it is desired to open the switch SM, the opto-electronic coupler is rendered inactive. The voltage at the output of its receiver (OPTO RX) reverts to zero volts; the first transistor TR1 and in turn the second transistor TR2 are turned off. Point Y is thus decoupled from the negative potential V1. The sudden decrease to zero of the current through the collector-emitter path of TR2 via inductor LP1 causes a substantial voltage to appear across the inductor LP1, the inductor current now flowing through diode D3. As the voltage across inductor LP1 decays, the potential at point Y rises towards the large positive potential V2, to which point Y is connected via the high resistance R3. The negative-going edge of the signal at the input to the circuit DPG causes this circuit to produce a pulse which turns on the third transistor TR3 for a short period; this pulse is produced after a short delay, by which time the potential at point Y is quite close to V2, and allows (while TR3 is on) a much larger current to flow beween the potential V2 and point Y than flows through the resistance R3. This helps to neutralise stored change in the PIN diodes D1 and D2, and hence the diodes D1 and D2 are turned off relatively rapidly. Once the diodes are reverse-biased and the third transistor TR3 is off again, the reverse bias is maintained via the high resistance R3.

In this embodiment, the third transistor TR3 is included only to enable the diodes D1 and D2 to be switched off rapidly. If such rapid switching is not required, the third transistor TR3, the associated circuit DPG and transformer T1, and the inductor LP1 and diode D3 may be omitted.

Since large RF voltages may be developed in use across an inductor that is not short-circuited, the bias voltage V2 used for reverse-biasing the diodes must be sufficiently large to ensure that the diodes remain reverse-biased when the direct bias voltage is opposed by the RF voltage. In the above-described embodiment, two diodes are used across respective halves of an inductor to ensure that this condition is satisfied, for a given bias voltage, with up to twice the RF voltage that would be permissible with a single diode across the whole inductor. If the value of an inductor is such that the anticipated maximum RF voltage across it can be handled by a single diode with the given bias voltage, an arrangement similar to that of Figures 2 and 3 may be used, with the modifications that the left-hand half of each inductor winding shown in Figure 2 then constitutes the whole winding and that diode D2 is omitted.

Instead of each of the inductors having three windings for supplying two different bias potentials and earth potential to the diode switch means, each of the inductors might have only two windings for supplying a single bias voltage control signals being coupled to the diode switch means so as to connect a diode therein to the bias voltage in one sense or the other according as the switch is selected to be open or closed. However, in view of the need for the voltage to be large to ensure that when it is desired that a diode should be off, the diode remains reverse-biased when the RF voltage opposes the bias voltage, this means that when a diode is forward-biased (for which only a relatively small voltage is required), it is necessary to include in the bias supply line within the switch means a series resistance in which a large amount of power will be dissipated during forward bias.

This disadvantage may be overcome if the switch comprises a three terminal switch device for short-circuiting the inductor; such a device may derive its power from a single bias voltage.

As an alternative to the opto-electronic coupler in the embodiment described with reference to the drawings, an inductor may be provided with an additional winding (or a respective additional winding) to couple signals for controlling the operation of the switch associated with the (or each) succeeding inductor. A source of control signals may then be connected to the additional winding(s) at the low-RF-potential end of the winding or set of windings in an analogous manner to the connection of the DC potentials in the described embodiment. The or each inductor may also be provided with a further winding to couple signals for controlling the operation of its own associated switch, for example where the control signals are supplied to a point that may be at a different RF potential from the end of the inductor nearer the source of control signals (as would be the case in an embodiment analogous to that described with reference to the drawings wherein the operating control circuit CTL may be at the RF potential of the mid-point of the inductor LM). Thus, with series of $\underline{N}$ inductors, the first inductor of the series may be provided with

($\underline{N}$ - 1) additional windings to supply control signals to the switches of the succeeding inductors, the second inductor with ($\underline{N}$ - 2) additional windings, and the $\underline{M}$th inductor with ($\underline{N}$ - $\underline{M}$) additional windings, and each inductor of the series may have one further winding for supplying control signals to its own associated switch.

A disadvantage of using additional windings on the inductors rather than opto-electronic couplers for coupling control signals to the switches is that the speed for switching may be reduced; the magnitude of the reduction will of course increase with the value of the inductance between the switch and the source of the control signals, and with a series of inductors will of course thus generally increase along the series.

In an RF circuit embodying the invention, the RF isolation provided by the inductive windings may also be utilised in supplying electrical power from the same source to switch means associated with another RF circuit element which is not a mainly inductive one but which may also be subject in use to large RF voltages. Thus for example in the embodiment described with reference to the drawings, wherein the variable capacitance CV of the ATU typically comprises the combination in parallel of a plurality of capacitors each in series with respective switch means, one terminal of each capacitor may be connected to the common line interconnecting terminals 1B and 2B, and the respective switch means may be connected between the other terminal of the capacitor and a winding of the series arm that is disposed between the source and the shunt arm (i.e. the left-hand series arm in Figure 1), at the interconnection of the series arms. The DC potentials required for the operation of the switch means may then be derived at the interconnection of the series arms from different respective windings of the series arm between the shunt arm and the source. To enable suitable RF isolation to be obtained, the switch means suitably comprise two diodes connected in series in the same sense. The reverse bias voltage therefore has to be divided between the two diodes, and accordingly should be approximately

0153777

twice that used for the diodes of the switch means across each of the inductors of the ATU; this necessitates an extra winding in each inductor of the series arm that is disposed between the shunt arm and the source of the reverse-bias potential. To avoid this, the order of connection of each of the capacitors and its associated switch means between the series arms and the RF ground line may be reversed, and each of the bias potentials for those switch means may be derived from the source via a supply choke analogous to SL1-SL3.

...
...
...
...

...

CLAIMS:

1. An RF circuit comprising at least one inductive element and electrically-operable switch means, wherein a point on said one inductive element is selectably electrically connectable in the operating RF range of the circuit to another point in the circuit by the switch means for passing a substantial RF current therebetween in use, and wherein RF isolation is provided between a source of electrical power required for the operation of the switch means and at least part of the switch means which in use is subjected to a large RF potential with respect to said source, characterised in that said one inductive element comprises a plurality of inductive windings which electrically are substantially in parallel with each other in the operating RF range of the circuit and substantially isolated from each other at DC, and in that the circuit is operable to supply from said source via at least two said windings to the switch means electrical power required for the operation thereof, whereby to provide said RF isolation.

2. A circuit as claimed in Claim 1 comprising a plurality of inductive elements connected in series with each other and further comprising a plurality of electrically-operable switch means each associated with a respective one of the inductive elements, characterised in that each of the inductive elements comprises a plurality of inductive windings and in that a plurality of respective windings of each element are respectively connected in series with respective windings of each of the other elements so that the circuit is operable to supply from said source via the windings to each of the switch means electrical power required for the operation thereof.

3. A circuit as claimed in Claim 1 or 2, wherein the or each switch means is selectably electrically connectable in parallel at RF with said one inductive element or a respective one of the inductive elements for substantially short-circuiting the element in the operating RF range of the circuit.

4. A circuit as claimed in any of Claims 1 to 3 further comprising opto-electronic means to couple signals to the, or at least one of the, switch means for controlling the operation thereof.

5. A circuit as claimed in any of Claims 1 to 3, wherein said one inductive element comprises an additional winding to couple signals to the, or its respective associated, switch means for controlling the operation thereof.

6. A circuit as claimed in Claim 2, or as claimed in Claim 3 or 5 as appendant to Claim 2, comprising $\underline{N}$ inductive elements, where $\underline{N} \geqslant 2$, connected in series with each another, wherein the $\underline{M}$th element of the series has $(\underline{N} - \underline{M})$ additional windings to couple signals to the switch means respectively asociated with the $(\underline{N} - \underline{M})$ succeeding elements of the series for controlling the operation thereof.

7. A circuit as claimed in any preceding claim wherein the or each switch means comprise at least one solid-state switch device.

8. A circuit as claimed in Claim 7, wherein said one or each inductive element comprises at least three windings and wherein the or each respective switch means comprise at least one solid-state two-terminal diode switch device biassable to two states respectively of high and low RF impedance by two respective direct voltages applied between the members of two respective pairs of the three windings.

9. A circuit as claimed in Claim 8, wherein a first terminal of said one two-terminal diode device of the or each switch means is coupled at DC and closely coupled at RF to a point on a first of said three windings of said one or the associated inductive element, wherein the second terminal of said one two-terminal diode device of the or each switch means is connected by a first path to a point on a second of said three windings of said one or the associated inductive element, the first path comprising in series between the second terminal and said point on the second winding first additional switch means selectably controllable to present either a high or a low DC resistance, and is connected by a second path to a point on the third winding of said one or the associated _____ _ _____nt, the second path comprising in series between the second terminal and said point on the third winding a high resistive DC impedance, and

wherein in use:

said points respectively on the second and third windings are at substantially the same RF potentials and are closely RF-coupled to said second terminal;

when the first additional switch means are controlled so as to present a low DC resistance, said one two-terminal diode device is DC-biassed via the first and second windings and the first path to its state of low RF impedance; and

when the first additional switch means are controlled so as to present a high DC resistance, said one two-terminal diode device is DC-biassed via the first and third windings and said high resistive DC impedance of the second path to its state of high RF impedance, said points on the second and third windings then each being at an RF potential differing from that of said point on the first winding.

10. A circuit as claimed in Claim 9 wherein the second path further comprises second additional switch means which are selectably controllable -to present either a high or a low DC resistance and which are connected in parallel with said high resistive DC impedance, and wherein in use the second additional switch means normally present a high DC resistance but when the first additional switch means are controlled so as to change from presenting a low DC resistance to presenting a high DC resistance, the second additional switch means are controlled so as briefly to present a low DC resistance whereby to increase the rate of change of biassing of said one two-terminal diode device from its low RF impedance state to its high RF impedance state.

11. A circuit as claimed in Claim 8, 9 or 10 wherein the or each switch means comprise two two-terminal diode devices whereof corresponding first terminals are respectively closely coupled at DC to opposite ends of a first of said three windings, and at RF to opposite ends of all three windings, of said one or the associated inductive element and whereof the corresponding second terminals are closely coupled together at DC and RF and closely coupled at RF to the mid-points of all three windings of said one or the associated inductive element.

12.    A circuit as claimed in any preceding claim comprising a further RF circuit element which is not mainly inductive and further switch means associated therewith, wherein in use at least part of said further element and at least part of said further switch means are at substantially the same RF potential as a point on the, or one of the, inductive element(s), characterised in that the circuit is operable to supply from said source via at least two of the windings to said further switch means electrical power required for the operation thereof.

13.    A circuit as claimed in any preceding claim in combination with said source of electrical power.

-------------------------

FIG.1

FIG.2

FIG.3